(19) **Europäisches Patentamt / European Patent Office / Office européen des brevets**

(11) **EP 2 408 133 A1**

(12) **EUROPEAN PATENT APPLICATION**

(43) Date of publication:
**18.01.2012 Bulletin 2012/03**

(51) Int Cl.:
*H04L 1/00* (2006.01)     *H03M 13/29* (2006.01)
*H03M 13/41* (2006.01)

(21) Application number: **10305781.6**

(22) Date of filing: **15.07.2010**

(84) Designated Contracting States:
**AL AT BE BG CH CY CZ DE DK EE ES FI FR GB GR HR HU IE IS IT LI LT LU LV MC MK MT NL NO PL PT RO SE SI SK SM TR**
Designated Extension States:
**BA ME RS**

(71) Applicant: **Thomson Licensing**
**92130 Issy-les-Moulineaux (FR)**

(72) Inventors:
• **Schmitt, Dirk**
 **78052, Pfaffenweiler (DE)**
• **Hoelzemann, Herbert**
 **78048, Villingen-Schwenningen (DE)**
• **Schone, Wiebke**
 **78052, Villingen-Schwenningen (DE)**

(74) Representative: **Thies, Stephan**
**Deutsche Thomson OHG**
**European Patent Operations**
**Karl-Wiechert-Allee 74**
**30625 Hannover (DE)**

(54) **Modified trellis decoding for erasure generation**

(57) For generating byte erasures (111, 114) for an outer decoding step (115) in an inner-outer error correction decoder having a Viterbi inner decoder (109), the invention proposes to flag a predefined number of least reliable bytes from the Viterbi inner decoder as erasures, and to approximate the byte reliability (608) by accumulating (C4) the metric differences (604) along the traceback path of the Viterbi inner decoder, or by accumulating QPSK demodulation distances ($\lambda$ (ri), $\lambda$ (rj)) of QPSK symbols contributing to the byte.

Fig. 1

EP 2 408 133 A1

## Description

### Field of the invention

The present invention relates to Error Correction Decoding in Digital Storage like DVD, BD, or HD-DVD; and in Set top boxes in DVB-T, DVB-S, DVB-S2, DVB-C; as well as in GSM, WLAN, and DSL.

### Background of the invention

For erasure generation in a modified trellis decoder, US5996103 purports to disclose an error correction arrangement that contains a Viterbi decoder and an RS decoder to provide inner and outer code decoding, respectively. A score keeper is arranged at the output of the Viterbi decoder to form a score for a decoded byte to indicate the number of error bits in the byte. A tie breaker is provided to compare the score with a preset threshold level. If the score is higher than the threshold level, the corresponding error byte is replaced with an erasure supplied to the RS decoder. The tie breaker in this patent is used to control the number of erasure flags by counting the number of erasures and tie the erasure flag to 0 if more than 2t byte erasures are generated. US5996103 can be seen to use a blind solution for erasure encoding, where all bytes are flagged whose reliability is under a certain threshold, so no weighting of the byte reliability is done.

Alternatively, US5023889 purports to disclose a trellis coded multilevel differential phase shift keyed mobile communication system that includes a trellis encoder for translating input signals into trellis codes; a differential encoder for differentially encoding the trellis coded signals; a transmitter for transmitting the differentially encoded trellis coded signals; a receiver for receiving the transmitted signals; a differential demodulator for demodulating the received differentially encoded trellis coded signals; and a trellis decoder for decoding the differentially demodulated signals. It can be seen to use a simple threshold comparison before the trellis decoder for detecting faded symbols, which are then flagged as erasures. "As an option for better performance, the envelope of the fading signal can be estimated and provided to the metric computer 48 and also can be used to create erasures for the Reed Solomon decoder. This can be done if the estimated fade sample is below a certain threshold". This method can be seen to have the disadvantage that only the investigated amplitude generates erasures.

Deng et al. "High Rate Concatenated Coding Systems Using Bandwidth Efficient Trellis Inner Codes", IEEE Trans. COM-37 No5, pp. 420-427, uses also a modified Viterbi algorithm. But this algorithm uses a double traceback: one for the ML path and one for the competitor path, to find a kind of reliability information. So the algorithm used in this paper is complex and needs big HW/SW resources. The impact of the algorithm in this paper is comparable with the impact of the SOVA algorithm.

US5181209 purports to disclose a method for generalizing the conventional Viterbi algorithm, in which the transition costs are formed in a metric increment unit (TMU) and adding, comparing and selection are performed in a succeeding add-compare-select (ACS) unit, the difference costs from two arriving paths are calculated for each individual state, the reliability information at the beginning of each path being set to the highest value. Then the reliability value of the path with the least costs is updated at the points where the information points differ from the competing path, updating being performed in accordance with a table, and where the prior value of the reliability information and the difference costs are inserted into the table as the new input values. Then this new value is taken from the table and is stored, together with hard decisions, as path memory, where storage can be in the form of fixed or floating point values. Finally the analog value decision is read out from the point which, after a decision delay, is the result for the path with the lowest cost and where the hard decisions of the conventional Viterbi algorithm are the sign of the analog value decision. By means of the method according to the invention a Viterbi algorithm has been created at the output of which analog value decisions, i.e. soft decisions are supplied. This can be seen to be one of the implementations of the SOVA algorithm. This algorithm needs more HW resources as multiple tracebacks have to be done to get the reliability of the symbol which should be demodulated.

### Invention

The invention suggests two approaches to generate erasures for a next decoding step. With erasure decoding the performance of the outer decoder can be enlarged as the error locations are already known using byte reliability information. With small modifications, the invention can also be included in a traditional trellis decoder. for this, the HW/SW size has to be increased only slightly compared to a reliability decoder as it has to be done for the SOVA or MAP.

The invention gives two solutions for generating byte erasures for the outer decoding step.

The first solution uses the branch metric distance to flag erasures for the decode bytes of the inner decoder. For this the byte reliabilities are sorted for one outer decoder frame (e.g. for an RS -packet) and only the N least reliable bytes are flagged as erasures.

The second solution uses a kind of accumulated metric difference to measure the reliability of the decision for the used maximum likelihood path during the traceback. The reliability is then used also in the sorting block to flag the N bytes which have the least reliability.

The invention has the advantages, that erasures are generated for the next decoding step of an outer decoder, that it has a small HW/SW modification, and that it has a small HW/SW size increase.

Drawings

Exemplary embodiments of the invention are illustrated in the drawings and are explained in more detail in the following description.
In the figures:

Fig. 1        shows decoder architectures without and with erasure handling between an inner decoder and an outer decoder;

Figure 2     shows the idea of the algorithm for reliability measurement of the received codeword decision using the Euclidian distance from a QPSK demodulation stage.

Figure 3     shows the integration of the erasure generator into the Viterbi algorithm schematic.

Figure 4     shows a trellis with 8 states and 4 stages.

Figure 5     shows an implementation of the second solution.

Figure 6     shows a detailed view of the block B3 in Figure 5.

Exemplary embodiments

Communication systems have to protect the transmitted information against different error classes like random error or burst errors. For digital satellite and terrestrial communication, jamming or fading can introduce burst errors. To protect the transmission against both error classes, concatenated codes comprising an inner code and an outer code are used to add redundancy to the transmitted symbols. In the receiver the added redundancy is used by the inner and outer decoder to detect errors introduced by the above mentioned influences. In most communication systems an inner code is used to protect the transmitted information against scattered random errors while the outer code is used for burst error correction. In the DVB-S and DSS standard a convolutional code is used as inner code while an RS code is used as outer code.

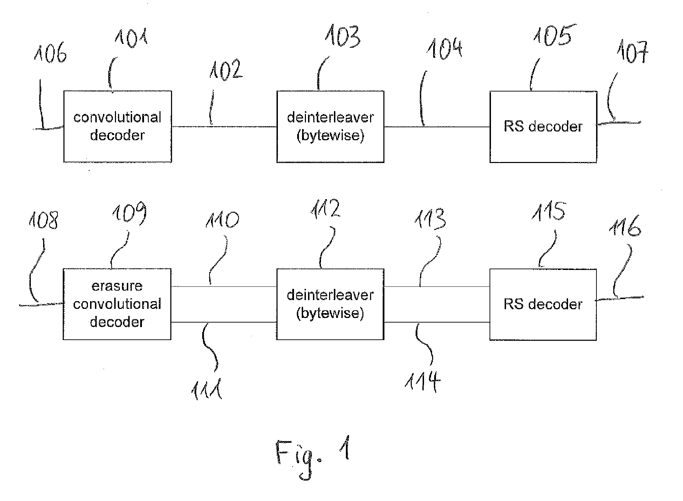

Fig. 1, in its upper part, shows a decoder architecture without erasure handling between an inner decoder and an outer decoder. After processing in an inner decoder 101, which may be a convolutional decoder, nothing but the decoded data 102 are passed to an outer decoder 105, which may be an RS decoder. Typically, as part of the data passing, the decoded data 102 are additionally passed through a deinterleaver 103.
It is well known from publications, for example, in the S. Lin and D. J. Costello, Jr. textbook, that a t-error correcting RS code is able to correct up to 2t erased bytes. That means that the error location should be known a priori. Therefore it is desirable to provide an inner decoder which calculates the potential error location and send this information to the outer decoder using erasure flags.
Fig. 1, in its bottom part, shows a decoder architecture with erasure handling between an inner decoder 109 and an outer decoder 115. Here, in parallel to the decoded data 110, 113 themselves, erasure information 111 is passed from the inner decoder 109 to the deinterleaver 112, and deinterleaved erasure information 114 is passed from the deinterleaver 112 to the outer decoder 115.
Many Patent publications exist which disclose to use these erasure information to process the erasure decoding. E.g. US 5023889 is using threshold comparison of the received symbol to generate erasure flags in front of the inner decoder. Several patents, like US 5996103, propose to forward the given erasure information stream from the inner decoder to the outer decoder.
In this invention two approaches of erasure generation in the inner decoder are given.
The **first solution** uses the information in the branch metric generator of the Viterbi decoder to flag unreliable received symbols, which are provided from the demodulation part. This is appropriate to any fading channel or channel where the amplitude of the received signal contains discontinuities due to interference (like in DVB-T). The method can be seen as hard decision based, as no "a posteriori" information of the inner code is used.
The **second solution** is a modification of the known Viterbi algorithm. For it, the reliability for the decision along the maximum likelihood path is measured by evaluating the metric differences.
Both solutions use only "local" estimates of the decision reliability, they do not use "global" estimates of the decision reliability as it is the case for the known SOVA or MAP algorithms. "Local" estimate is understood here to denote that the decision of one bit is made by a sequence detection but the weighting factor (reliability) of this decision is made only at this state without any traceback on the competitor path as it is done for SOVA. In SOVA it is important that you are measuring the reliability of a current decision using also prior decisions. that means that you also use decisions and their reliability which have been made right before your current decision. Therefore it is a global estimate over the entire trellis.
By virtue of using only "local" estimates of the decision reliability, the solutions of this invention are likely to be outperformed by the known SOVA or MAP methods. However, they advantageously have a smaller HW/SW effort, which is only slightly higher than for the known Viterbi algorithm.
Also, solutions 1 and 2 can easily be added to a classical Viterbi decoder without conceptually changing the algorithm of the Viterbi decoder.

**Solution 1**:

In the first solution, the minimum distance between the received symbol and the nearest neighbor is evaluated for each bit using the branch metric unit of the classical Viterbi. To evaluate the distance algorithms like the Hamming distance or the Euclidian distance can be used.

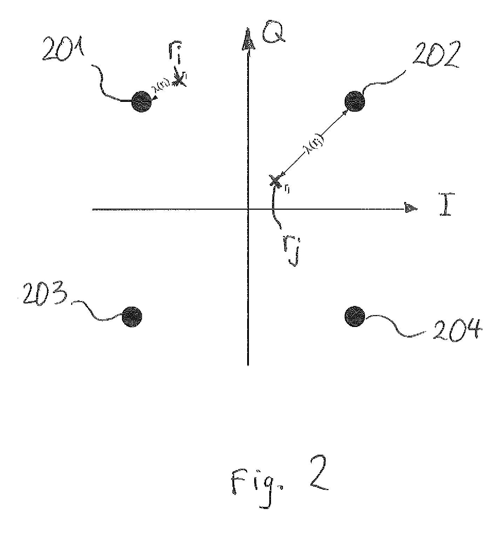

**Fig. 2** illustrates the idea of solution 1, i.e. deriving a reliability measurement of the received codeword decision from the Euclidian distance of the pertaining QPSK symbols towards their respective closest QPSK configuration points. Two received symbols $r_i$, $r_j$ are shown by an "X" symbol in the complex I,Q plane, where $r_i$ is closest to the top left QPSK point 201, and $r_j$ is closest to the top right QPSK point 202, in such a way that the reliability $\lambda(r_i)$ of the decision for $r_i$ is higher (the Euclidian distance is smaller) than the reliability $\lambda(r_j)$ of the decision for the received symbol $r_j$. With each QPSK symbol conveying 2 bits, a total of 4 QPSK symbols convey the bits of 1 byte, and a reliability estimate for the byte is obtained by accumulating the Euclidian distances of the 4 pertaining QPSK symbols.

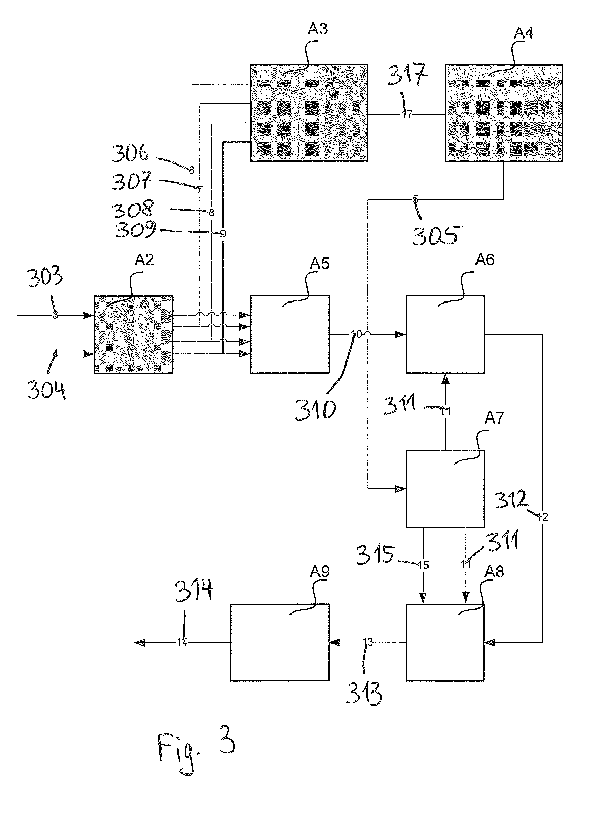

**Fig. 3** shows a hardware configuration that allows to calculate the above described reliability estimate using hardware components that are anyway present as parts of a Viterbi decoder implementation. The quadrature signal components I 303 and Q 304 from a not shown QPSK demodulator are input to a branch metric calculator A2. The branch metric calculator A2 is used to calculate the euclidian distance between the current QPSK symbol represented by I and Q, and the 4 QPSK configuration points 201-204. A first output 306 of the branch metric calculator A2 carries the distance of I,Q from the configuration point 201 representing a QPSK symbol "00", a second output 307 carries the distance of I,Q from symbol "01, a third output 308 carries the distance of I, Q from symbol "10", and a fourth output 309 carries the distance of I,Q from symbol "11". The first through fourth output 306-309 are input to a Min logic A5, which delivers at its output 310 the minimum of the four distances corresponding to $\lambda(r_i)$, $\lambda(r_j)$ above. The output 310 of the min logic A5 characterizes how good the hard decision for the current symbol is. The QPSK decision "reliability" 310 is then fed to an accumulator A6 which accumulates the decision reliability for one byte, to yield the byte reliability 312 according to

$$\lambda(V_k) = \sum_i \lambda_k(r_i)$$

, where $V_k$ is the k-th received byte and $\lambda(V_k)$ is the "byte reliability" thereof.

A timer block A7 triggers a reload of the accumulator A6 every time one byte has completely been received using a byte strobe signal 311. The timer block A7 is synchronized by a sync strobe 305, which is generated by a frame sync detector A4. If an MPEG (e.g. for DVB-T, DVB-S) or a DSS stream is selected the frame length is known and the location of the sync byte can be easily detected. This synchronization signal 305 is then used to synchronize the timer block A7 to the correct byte boundaries. The timer block A7 also generates a packet strobe signal 315 to reset the whole logic, if one RS packet is passed. The byte "reliability" 312 is then fed to a shift register logic A8 at every byte strobe 311. The shift register A8 is cleared at every sync strobe it receives from the timer block A7 and it holds the n biggest byte reliabilities and their index in the current packet. The value n can be variable and depends on how many erasures should be generated in one packet. It is possible to set this value by a software register or a variable if the system is implemented in software. An erasure inserter A9 triggers an erasure flag 314 to the subsequent not shown outer decoder for the non-reliable received bytes. For this the erasure inserter A9 has to do the correct inserting of the erasure flags regarding to the outgoing bitstream 317 of the inner decoder A3.

This solution constitutes a "local" erasure estimation, because the decisions on the erasure flags are done without using the trellis information given by the inner decoder. Therefore the solution is applicable to any burst errors which introduce a degradation of the received signal.

A better solution but with higher efforts is given by the paper "High rate concatenated coding systems using bandwidth efficient trellis inner codes". To reduce the effort of this proposed algorithm, solution 2 is now developed using a "local" estimate by the branch metrics and a "global" estimate of the byte reliability by the trellis.

**Solution 2:**

Solution 2 uses metric differences as defined in "A Viterbi algorithm with soft-decision outputs and its applications". The calculation of the metric differences is done using the traditional add-compare-select or ACS logic of the Viterbi decoder. So the metric difference is given by the following equation:

$$\Delta_{i,k} = (\alpha_{i,k-1} + \gamma_{i,k}) - (\alpha'_{i,k-1} + \gamma'_{i,k}) \ ,$$

where $\alpha_{i,k-1}$ is the path metric of the winning state in stage k-1; $\gamma_{i,k}$ is the branch metric from the winning state to the current state; where $\alpha'_{i,k-1}$ is the path metric of the competitor state in stage k-1; and $\gamma'_{i,k}$ is the branch metric from the competitor state to the current state.

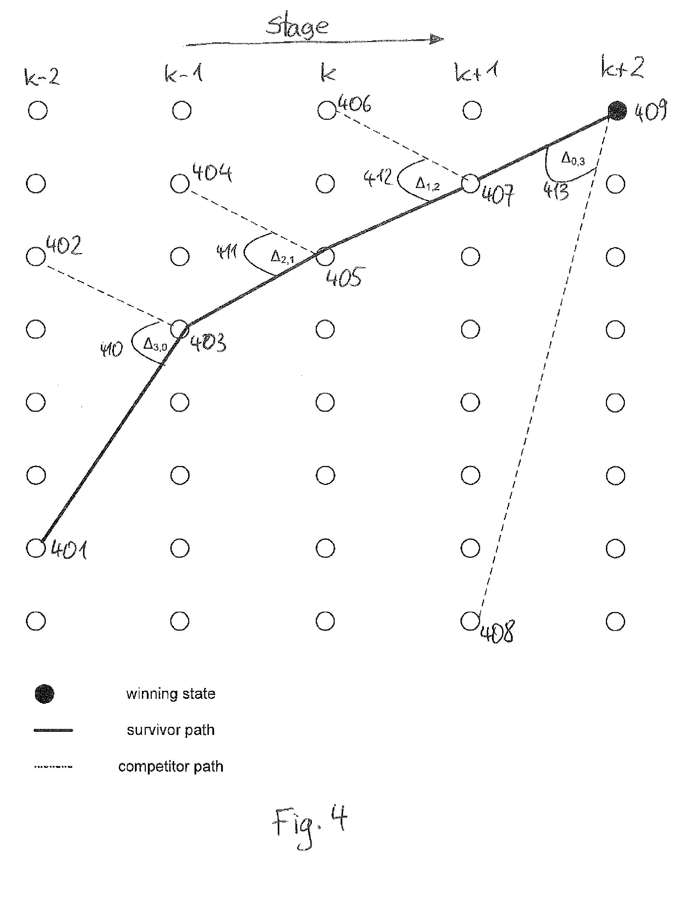

**Fig. 4** shows a trellis with 8 states and 5 stages. In the trellis only the ML path (or survivor path) is indicated with a solid line. This is the path that joins the winning states starting from the oldest stage. Also the metric differences and the competitor path along the ML path are shown in the Figure with a dotted line.

The gist of solution 2 is situated in the traceback procedure. The traceback algorithm starts at the winning state 409 of stage k+2 shown in bold in the Figure, and steps along the ML path through all winning states of the current stage. Every time the traceback comes to one state, the metric difference is added to a global metric difference value.

Since the metric difference is an indication of the reliability of the decision for choosing the winning state over the competitor path, this sum of metric differences yields a global path reliability estimate.

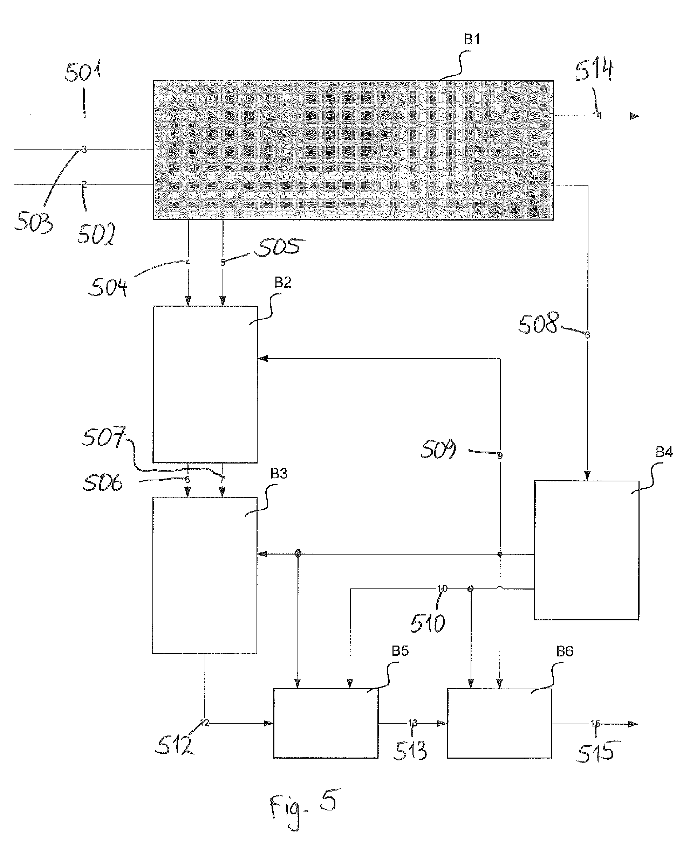

**Figure 5** shows an implementation of the second solution. The block B1 is the traditional Viterbi decoder, i.e. a trellis decoder, which uses the incoming received samples 501, 502 and their enable signal 503 to do a maximum likelihood decision. The enable signal 503 is used for indication of the optimum sampling point. In this Viterbi decoder, the not shown ACS unit is used to generate the metric differences 504 and the survivor path indication 505, which is then stored in a memory B2. After some samples are collected, a traceback unit B3 begins to work to identify the ML path. For this, the survivor path decisions 506 are used.

It is not a part of this invention how the traceback B3 is working, many known solutions exist for this. The traceback B3 in this invention is only used for identifying the ML path, it doesn't matter how the traceback is solved.

During the traceback from each survivor step to the previous one, as illustrated in Figure 4, a not shown accumulator collects the metric differences 507 between each survivor path transition and the related competitor path transition for one byte.

A timer unit B4 indicates the start and the end of each byte. For this, the timer unit is synchronized with the sync strobe signal 508 which is provided by the internal frame sync detector of the trellis decoder B1. The timer generates a byte strobe signal 509 to indicate which stage is related to which byte and a packet strobe signal 510 used later on in a shift register B5 and a block B6.

The shift register B5 has the same functionality as the shift register for solution 1. The shift register B5 receives the incoming byte reliability 512 and does a sorting where the least reliability is stored on top of the shift register. The packet strobe signal 510 is used to reset the shift register B5, so that the shift registers know when a new byte reliability ordering should be started.

After a packet strobe pulse 510 the shift register provides the indexes of those n bytes that have the smallest reliability. The erasure encoder receives these indices 513 and inserts the erasure flags in the right byte position regarding to the outgoing decoded bitstream 514 of the Viterbi decoder B1.

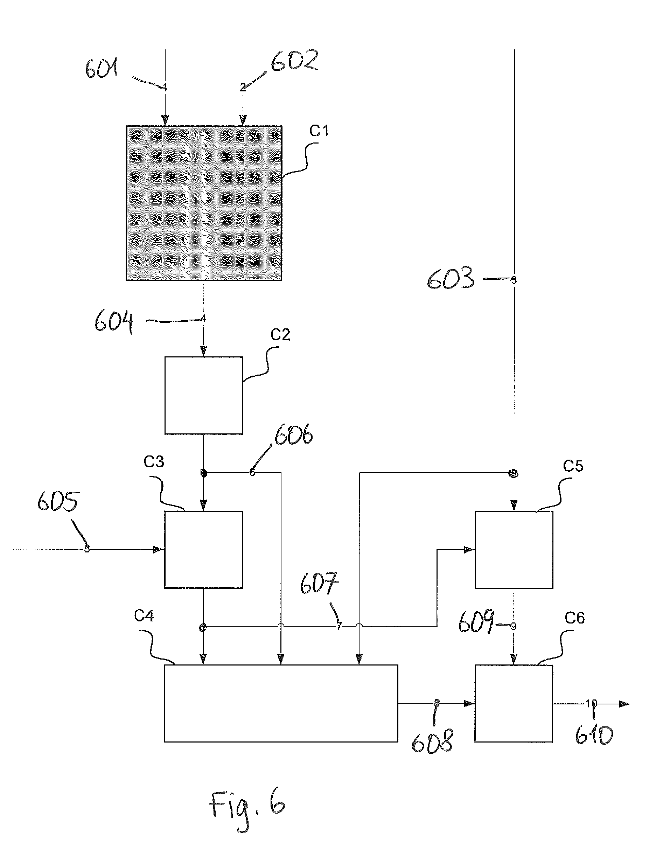

**Figure 6** is a detailed view of the tracebeck block B3 in Figure 5. A traceback logic c1 receives the survivor path decision 601 and the metric difference 602 between the current survivor state and the competitor state provided by the traceback memory in Figure 5. The traceback logic sends the metric differences 604 which is related to the decided traceback path to an absolute value logic C2, which outputs the absolute value 606 of the metric difference. The absolute metric difference 606 is then fed to a comparator C3 which enables the next steps using an enable signal 607 if the metric difference is above a certain threshold value 605. This threshold value 605 can be set independently by software if a hardware decoder is used or by a variable if a software decoder is used. So the user is able to control the number of erasure bytes by setting the threshold of the threshold comparator.

The enable pulses 607 from the threshold comparator C3 are counted by a counter C5 which is reset at every byte strobe 603. The accumulator C4 accumulates the absolute metric difference every time a pulse is sent out by the threshold comparator C3 and is reset if a byte strobe is triggered by the timer block B4. After the metric difference which reflects the byte reliability is accumulated between two byte strobes, the accumulator shifts out the current value 608 to a normalizer block C6. The normalizer C6 then divides the accumulated metric difference 608 for the current byte by the number of accumulated metric differences 609 to give a reliability 610 of the current byte decision.

With other words, for generating byte erasures 111, 114 for an outer decoding step 115 in an inner-outer error correction decoder having a Viterbi inner decoder 109, the invention proposes to flag a predefined number of least reliable bytes from the Viterbi inner decoder as erasures, and to approximate the byte reliability 608 by accumulating C4 the metric differences 604 along the traceback path of the Viterbi inner decoder, or by accumulating QPSK demodulation distances $\lambda$ (ri), $\lambda$ (rj) of QPSK symbols contributing to the byte.

**Claims**

1. **Method** for generating byte erasures for an outer decoding step in an inner-outer error correction decoder having a Viterbi inner decoder, **characterized in that** a predefined number of least reliable bytes from the Viterbi inner decoder are flagged as erasures, and **in that** the reliability of a byte is approximated by accumulating metric differences along a traceback path of the Viterbi inner decoder.

2. A method according to claim 1, wherein the reliability of a byte is approximated by accumulating the metric differences of competitor branches along the traceback path of the Viterbi inner decoder.

3. **Method** for generating byte erasures for a outer decoding step in an inner-outer error correction decoder having a Viterbi inner decoder whose input is derived from QPSK symbols from a QPSK demodulator,
**characterized in that**
a predefined number of least reliable bytes from the Viterbi inner decoder are flagged as erasures, and **in that** the reliability of a byte is approximated by accumulating the Euclidian distances of the QPSK symbols contributing to the byte.

4. A **method** according to claim 3, wherein the accumulation of Euclidian distances is done with components of the Viterbi inner decoder.

| convolutional decoder | | deinterleaver (bytewise) | | RS decoder |

| erasure convolutional decoder | | deinterleaver (bytewise) | | RS decoder |

Fig. 1

Fig. 2

Fig. 3

Stage →

k-2    k-1    k    k+1    k+2

Fig. 4

winning state

survivor path

competitor path

Fig. 5

Fig. 6

Europäisches
Patentamt

European
Patent Office

Office européen
des brevets

# EUROPEAN SEARCH REPORT

**Application Number**

EP 10 30 5781

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| Y | US 2010/058429 A1 (CHOI IN HWAN [KR] ET AL) 4 March 2010 (2010-03-04) <br> * paragraphs [0014] - [0016] * <br> * paragraph [0477] * <br> * paragraphs [0495] - [0496] * <br> * paragraphs [0501] - [0502] * <br> * paragraphs [0536] - [0538] * <br> * paragraphs [0543] - [0544] * <br> * paragraphs [0551] - [0556] * <br> * figures 41,46,50-52 * <br> ----- | 1,2 | INV. <br> H04L1/00 <br> H03M13/29 <br> H03M13/41 |
| Y | 31 December 2007 (2007-12-31), , XP002610477 <br> 3.1 <br> Figure 11-2 <br> ----- | 1,2 | |
| L | Michael Hooks, Viterbi Family Archivist: "Finding Aid for the Andrew J. and Erna Viterbi Family archives, 1905-20070335 (extract of pages 1-5, 241-242)"[Online] 31 December 2008 (2008-12-31), XP002610478 Online Archive of California Retrieved from the Internet: URL:http://www.oac.cdlib.org/data/13030/h1/kt7199r7h1/files/kt7199r7h1.pdf> [retrieved on 2010-11-19] <br> * page 2 * <br> * page 242 * <br> ----- | 1,2 | **TECHNICAL FIELDS SEARCHED (IPC)** <br><br> H04L <br> H03M |

~~The present search report has been drawn up for all claims~~

| Place of search | Date of completion of the search | Examiner |
|---|---|---|
| Munich | 22 November 2010 | Meister, Mark |

CATEGORY OF CITED DOCUMENTS

X : particularly relevant if taken alone
Y : particularly relevant if combined with another
   document of the same category
A : technological background
O : non-written disclosure
P : intermediate document

T : theory or principle underlying the invention
E : earlier patent document, but published on, or
   after the filing date
D : document cited in the application
L : document cited for other reasons
........................................................................
& : member of the same patent family, corresponding
   document

EPO FORM 1503 03.82 (P04C01)

Europäisches
Patentamt

European
Patent Office

Office européen
des brevets

**Application Number**

EP 10 30 5781

---

## CLAIMS INCURRING FEES

The present European patent application comprised at the time of filing claims for which payment was due.

☐ Only part of the claims have been paid within the prescribed time limit. The present European search report has been drawn up for those claims for which no payment was due and for those claims for which claims fees have been paid, namely claim(s):

☐ No claims fees have been paid within the prescribed time limit. The present European search report has been drawn up for those claims for which no payment was due.

---

## LACK OF UNITY OF INVENTION

The Search Division considers that the present European patent application does not comply with the requirements of unity of invention and relates to several inventions or groups of inventions, namely:

see sheet B

☐ All further search fees have been paid within the fixed time limit. The present European search report has been drawn up for all claims.

☐ As all searchable claims could be searched without effort justifying an additional fee, the Search Division did not invite payment of any additional fee.

☐ Only part of the further search fees have been paid within the fixed time limit. The present European search report has been drawn up for those parts of the European patent application which relate to the inventions in respect of which search fees have been paid, namely claims:

☒ None of the further search fees have been paid within the fixed time limit. The present European search report has been drawn up for those parts of the European patent application which relate to the invention first mentioned in the claims, namely claims:

1, 2

☐ The present supplementary European search report has been drawn up for those parts of the European patent application which relate to the invention first mentioned in the claims (Rule 164 (1) EPC).

14

Europäisches
Patentamt

European
Patent Office

Office européen
des brevets

**LACK OF UNITY OF INVENTION
SHEET B**

Application Number

EP 10 30 5781

The Search Division considers that the present European patent application does not comply with the requirements of unity of invention and relates to several inventions or groups of inventions, namely:

1. claims: 1, 2

   A method for generating byte erasures for an outer decoding step in an inner-outer error correction decoder having a Viterbi inner decoder, wherein a predefined number of least reliable bytes from the Viterbi inner decoder are flagged as erasures, and wherein the reliability of a byte is approximated by accumulating metric differences along a traceback path of the Viterbi inner decoder.
   ---

2. claims: 3, 4

   A method for generating byte erasures for a outer decoding step in an inner-outer error correction decoder having a Viterbi inner decoder whose input is derived from QPSK symbols from a QPSK demodulator, wherein a predefined number of least reliable bytes from the Viterbi inner decoder are flagged as erasures, and wherein the reliability of a byte is approximated by accumulating the Euclidian distances of the QPSK symbols contributing to the byte.
   ---

## ANNEX TO THE EUROPEAN SEARCH REPORT
## ON EUROPEAN PATENT APPLICATION NO.

EP 10 30 5781

This annex lists the patent family members relating to the patent documents cited in the above-mentioned European search report.
The members are as contained in the European Patent Office EDP file on
The European Patent Office is in no way liable for these particulars which are merely given for the purpose of information.

22-11-2010

| Patent document cited in search report | Publication date | Patent family member(s) | Publication date |
|---|---|---|---|
| US 2010058429 A1 | 04-03-2010 | WO 2010024590 A2 | 04-03-2010 |

EPO FORM P0459

For more details about this annex : see Official Journal of the European Patent Office, No. 12/82

## REFERENCES CITED IN THE DESCRIPTION

**Patent documents cited in the description**

- US 5996103 A
- US 5023889 A

- US 5181209 A

**Non-patent literature cited in the description**

- **DENG et al.** High Rate Concatenated Coding Systems Using Bandwidth Efficient Trellis Inner Codes. *IEEE Trans. COM,* vol. 37 (5), 420-427